# EUROPÄISCHE PATENTSCHRIFT

(11) **EP 3 347 988 B1**
(45) Veröffentlichungstag und Bekanntmachung des Hinweises auf die Patenterteilung: **22.06.2022**
(21) Anmeldenummer: 16760508.8
(22) Anmeldetag: 06.09.2016
(51) Int. Cl.: H03K 17/687, B60R 16/02, F02D 41/20, B60T 8/88, H01F 7/18, H03K 17/16

(54) **SCHALTVORRICHTUNG UND EIN VERFAHREN ZUM SCHALTEN VON VERBRAUCHERN**
SWITCHING DEVICE AND METHOD FOR SWITCHING LOADS
DISPOSITIF DE COMMUTATION ET PROCÉDÉ DE COMMUTATION DE CONSOMMATEURS

(30) Priorität: 10.09.2015 DE 102015115280
(43) Veröffentlichungstag der Anmeldung: 18.07.2018
(73) Patentinhaber: KNORR-BREMSE Systeme für Nutzfahrzeuge GmbH, 80809 München (DE)
(72) Erfinder: SCHOLL, Frank, 74379 Ingersheim (DE); APPL, Johannes, 74343 Sachsenheim (DE); BELLING, Michael, 71272 Renningen (DE)
(86) Internationale Anmeldenummer: PCT/EP2016/070901
(87) Internationale Veröffentlichungsnummer: WO 2017/042139

(56) Entgegenhaltungen:
- DE-A1- 19 513 621
- DE-A1-102008 001 114
- DE-A1-102011 089 228
- DE-A1-102012 203 940
- DE-A1-102012 214 774

## Beschreibung

Die vorliegende Erfindung bezieht sich auf eine Schaltvorrichtung und ein Verfahren zum Schalten von Verbrauchern und insbesondere zum Schalten von Aktuatoren.

### Hintergrund

Zur Vermeidung von ungewollten Aktivierungen von Verbrauchern (wie beispielsweise von Aktuatoren) in sicherheitsrelevanten Anwendungen, werden in Steuergeräten häufig sowohl der positive als auch der negative Anschluss geschaltet. Eine derartige Doppelabsicherung kommt beispielsweise in Antiblockiersystemen oder elektronischen Bremssystemen zum Einsatz, wobei die Aktuatoren beispielsweise druckgesteuerte Ventile (PCV) sind. Dabei kann einer der beiden Schalter für mehrere Aktuatoren gemeinsam ausgeführt sein und kann während des Betriebes dauernd eingeschaltet bleiben. Darüber hinaus können weitere Schalter vorgesehen sein, die durch ein Verbinden einzelner Anschlüsse die Aktuatoren einzeln aktivieren können (z.B. bei einem Regeleingriff), so dass gezielt einzelne Aktuatoren angesteuert werden können.

Für den Fall, dass eine Verbindung zu dem positiven Anschluss durch einen gemeinsamen Schalter (Highside-Schalter) geschaltet werden soll, besteht häufig das Problem, dass ein dauerhaft anliegendes positives Potential zu Korrosion an den Steckern zu den Aktuatoren führt. Deshalb werden bei konventionellen Systemen gemeinsame Schalter für den negativen Anschluss (Lowside-Schalter) verwendet und die Aktivierung einzelner Aktuatoren erfolgt durch einzelne Highside-Schalter. Durch den dauerhaft eingeschalteten (geschlossenen) Lowside-Schalter liegt somit kein Potential zwischen den Aktuatoren und der Masse (z.B. Fahrzeugmasse) an. Dadurch wird das Problem der Korrosion vermieden. Häufig wird den Highside-Schaltern ein weiterer, zusätzlicher Highside-Schalter vorangestellt, der beispielsweise als ein Relais oder als ein Halbleiterschalter ausgebildet sein kann und der bei einer Systemabschaltung oder im Fall eines Defekts eines Highside-Schalters das positive Potential der Batterie vom System trennt.

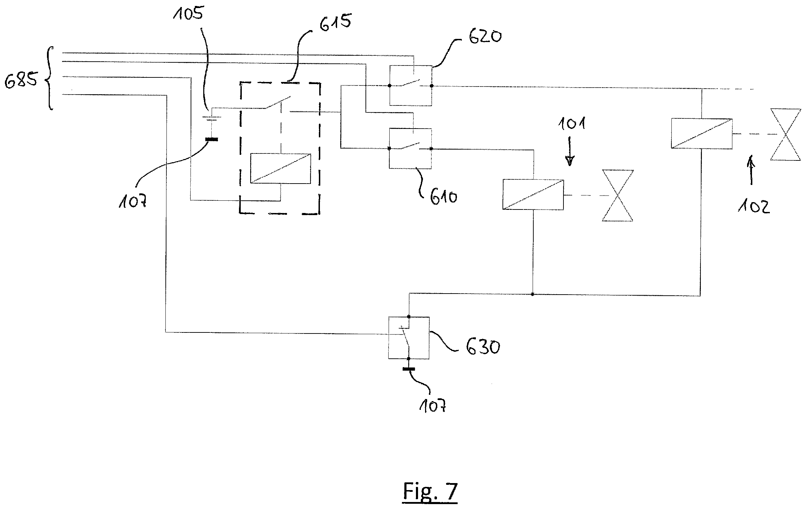

Fig. 7 zeigt ein solches konventionelles Schaltkonzept. Es basiert auf einem gemeinsamen Lowside-Schalter und einzelne Highside-Schalter. Beispielsweise kann für jedes Ventil bei Aktuatoren für ABS- oder EBS-Steuergeräte ein separater Highside-Schalter vorhanden sein.

Im Detail zeigt die Fig. 7 einen ersten Aktuator 101, einen zweiten Aktuator 102, einen ersten Highside-Schalter 610, einen zweiten Highside-Schalter 620, einen dritten Highside-Schalter 615 und einen Lowside-Schalter 630. Außerdem ist in dem Schaltkonzept der Fig. 7 eine Spannungsquelle 105 vorhanden, die mit einem Pol auf Masse 107 liegt. Der andere Pol (Highside) stellt eine Stromversorgung für die Verschaltung bereit.

Der Lowside-Schalter 630 ist dabei elektrisch sowohl zwischen dem ersten Aktuator 101 und der Masse 107 als auch zwischen dem zweiten Aktuator 102 und der Masse 107 geschaltet. Der erste Aktuator 101 ist zwischen dem ersten Highside-Schalter 610 und dem Lowside-Schalter 630 angeordnet. Der zweite Aktuator 102 ist zwischen dem zweiten Highside-Schalter 620 und dem Lowside-Schalter 630 angeordnet. Der dritte Highside-Schalter 615 ist zwischen der Spannungsquelle 105 (d.h. dem Pol, der nicht auf Masse liegt) und dem ersten Highside-Schalter 610 geschaltet, als auch zwischen der Spannungsquelle 105 und dem zweiten Highside-Schalter 620 geschaltet. Der Lowside-Schalter 630, der erste Highside-Schalter 610, der zweite Highside-Schalter 620 und der dritte Highside-Schalter 615 werden über Steuerleitungen 685 angesteuert und können somit durch eine Steuereinheit (nicht in der Fig. 7 gezeigt) selektiv geöffnet oder geschlossen werden, um Strompfade durch den ersten Aktuator 101 und/oder den zweiten Aktuator 102 selektiv bereitzustellen oder zu unterbrechen.

Außerdem können weitere Aktuatoren vorhanden sein, die in der Fig. 7 nicht gezeigt sind, die aber ebenfalls separate, weitere Highside-Schalter aufweisen, wobei jeweils ein weiterer Aktuator zwischen dem jeweiligen weiteren Highside-Schalter und dem Lowside-Schalter 630 geschalten ist. Somit sind auch diese weiteren, zusätzlichen Aktuatoren über den dritten Lowside-Schalter 630 mit der Masse 107 verbunden. Im Fehlerfall kann der gemeinsame Lowside-Schalter 630 daher alle Aktuatoren stromlos schalten. Ebenso dient der in der Fig. 7 als Relais dargestellte dritte Highside-Schalter 615 dazu, die Aktuatoren im Fehlerfall stromlos zu schalten und das positive Potential der Batteriespannung 101 vom System zu trennen. Die Aktuatoren können beispielsweise elektropneumatische oder elektrohydraulische Ventile darstellen.

Highside-Schalter sind jedoch in der Regel aufwendig und nicht als Massenprodukt zu geringen Kosten verfügbar. Andererseits enthalten verfügbare anwendungsspezifische integrierte Schaltungen (ASICs) häufig leistungsfähige Lowside-Schalter, deren Funktionen häufig nicht optimal eingesetzt werden. Ebenso sind verfügbare Einzel-Lowside-Schalter oder Mehrfach-Lowside-Schalter preisgünstiger und leistungsfähiger als entsprechende Highside-Schalter. Um solche Schalter in einem System und für die Schaltung von Aktuatoren nutzen zu können, ist das Schaltkonzept zu ändern.

DE 19513621A1 offenbart eine weitere konventionelle Vorrichtung zur Ansteuerung von zwei Gruppen von Verbrauchern, die mittels zumindest Schaltern auswählbar sind. DE 10 2008 001 114 A1 offenbart eine weiter konventionelle Steuerschaltung, die vor Verpolungen von Glühstiftkerzen schützt. In DE 10 2011 089 228 A1 ist eine weitere konventionelle Vorrichtung zum Ansteuern elektrisch betätigter Ventile offenbart, die eine Freilaufschaltung nutzt, um einen effektiven pulsweiten-moduliertes Schaltbetrieb zu ermöglichen. DE 10 2012 214 774 A1 offenbart eine weitere bekannte Schaltungsanordnung in einem Kraftfahrzeugsteuergerät und DE 10 2012 203 940 A1 offenbart ein bekanntes Steuergerät für eine Getriebesteuerung.

Der vorliegenden Erfindung liegt die Aufgabe zugrunde, eine Schaltvorrichtung und ein Verfahren zum Schalten von Verbrauchern bereitzustellen, die die oben genannten Nachteile überwinden.

### Zusammenfassung

Diese Aufgabe wird durch eine Schaltvorrichtung nach Anspruch 1 und ein Verfahren zum Schalten nach Anspruch 10 gelöst. Die abhängigen Ansprüche beziehen sich auf vorteilhafte Weiterbildungen der Gegenstände der unabhängigen Ansprüche.

Die vorliegende Erfindung bezieht sich auf eine Schaltvorrichtung zum Schalten eines ersten Aktuators und eines zweiten Aktuators zwischen einer Stromversorgung und einer Masse, wie sie im Anspruch 1 definiert ist.

Unter Schalten soll sowohl das Öffnen als auch das Schließen eines elektrischen Strom-pfades verstanden werden, so dass sich elektrische Ladungsträger entlang des Strompfades bewegen können. Ebenfalls ist der Begriff Aktuator breit auszulegen und kann alle Formen von Verbrauchern und Lasten umfassen, die durch eine Stromzufuhr entsprechend betrieben oder aktiviert werden.

In weiteren Ausführungsbeispielen ist der erste Schalter und der zweite Schalter jeweils ein Lowside-Schalter, und der dritte Schalter ist ein Highside-Schalter.

In weiteren Ausführungsbeispielen umfassen der erste Schalter und/oder der zweite Schalter und/oder der dritte Schalter eine Halbleiterschalteinheit oder ein Relais. In weiteren Ausführungsbeispielen umfasst die Halbleiterschalteinheit einen Feldeffekttransistor. Der Feldeffekttransistor kann jede Art von Feldeffekttransistoren umfassen, der zum Schalten geeignet ist, wie beispielsweise einen MOSFET, MISFET, JFET, IGFET. In weiteren Ausführungsbeispielen kann der Feldeffekttransistor durch einen Bipolar-Transistor oder ein anderes schaltfähiges Halbleiterbauelement ersetzt werden.

In weiteren Ausführungsbeispielen ist der Feldeffekttransistor des ersten Schalters ein erster Feldeffekttransistor und der Feldeffekttransistor des zweiten Schalters ist ein weiterer Feldeffekttransistor und die Schaltvorrichtung umfasst weiter ein erstes Spannungsbegrenzungselement (z.B. eine Zener-Diode) und ein weiteres Spannungsbegrenzungselement (z.B. eine Zener-Diode). Das erste Spannungsbegrenzungselement kann parallel zum ersten Feldeffekttransistor und das weiteres Spannungsbegrenzungselement kann parallel zum weiteren Feldeffekttransistor ausgebildet sein (bzw. geschaltet sein), wobei das erste und das weitere Spannungsbegrenzungselement derart angeordnet sind, dass sie im Normalbetrieb einen Stromfluss unterdrücken und bei Überschreiten einer Mindestspannung leitend werden, um so Spannungsspitzen über den ersten und den weiteren Feldeffekttransistor zu vermeiden.

Das Spannungsbegrenzungselement kann jede Art von Halbleiterbauelement sein, welches geeignet ist, einen Überspannungsschutz bereitzustellen, d.h. einen spannungsabhängigen Widerstand aufweist und insbesondere oberhalb der Mindestspannung leitfähig wird.

Gemäß der Erfindung umfasst der dritte Schalter eine erste Schalteinheit und eine zweite Schalteinheit, die seriell geschaltet sind und durch die Steuereinheit unabhängig voneinander schaltbar sind.

In weiteren Ausführungsbeispielen umfassen die erste Schalteinheit und die zweite Schalteinheit des dritten Schalters jeweils ein Halbleiterbauelement (z.B. einen Feldeffekttransistor) und sind antiseriell miteinander verschaltet, um einen Verpolungsschutz zu bieten.

In weiteren Ausführungsbeispielen ist die erste Schalteinheit zwischen der zweiten Schalteinheit und der Stromversorgung geschaltet und parallel zum Halbleiterbauelement der zweiten Schalteinheit ist ein Spannungsbegrenzungselement ausgebildet.

Viele Aktuatoren werden magnetisch betrieben und umfassen beispielsweise einen Elektromagneten, der beim Stromfluss beispielsweise Ventile öffnet oder schließt oder andere Operationen ausführt. Bei einem plötzlichen Abschalten derartiger Aktuatoren enthält das elektromagnetische Feld immer noch ausreichend Feldenergie, die sich nicht sofort abschalten lässt. Daher kann ein "Löschen" der Aktuatoren sinnvoll sein, bei welchem diese noch vorhandene Feldenergie in dem System beseitigt wird. Das Löschen kann dabei langsam oder schnell erfolgen.

Optional kann in weiteren Ausführungsbeispielen die zumindest eine Zusatzdiode mehrere Zusatzdioden umfassen, die derart geschaltet sind, dass zu dem ersten und zu dem zweiten Aktuator jeweils eine der mehreren Zusatzdioden parallel geschaltet sind.

Optional ist in weiteren Ausführungsbeispielen die Steuereinheit ausgebildet, um den dritten Schalter vor oder nach dem ersten Schalter oder vor oder nach dem zweiten Schalter zu schließen oder zu öffnen.

Gemäß der Erfindung ist die Steuereinheit ausgebildet, um durch ein Öffnen der ersten und/oder der zweiten Schalteinheit ein langsames Löschen des ersten Aktuators und/oder des zweiten Aktuators zu ermöglichen. Die Steuereinheit ist außerdem ausgebildet, um durch ein Öffnen der ersten und/oder der zweiten Schalteinheit ein schnelles Löschen des ersten Aktuators und/oder des zweiten Aktuators zu ermöglichen.

Die vorliegende Erfindung bezieht sich auch auf ein Bremssystem eines Fahrzeuges mit zumindest einem ersten druckgesteuerten Ventil und einem zweiten druckgesteuerten Ventil und einer zuvor beschriebenen Schaltvorrichtung, wobei der erste Aktuator das erste druckgesteuerte Ventil ist und der zweite Aktuator das zweite druckgesteuerte Ventil ist.

Die vorliegende Erfindung bezieht sich auch auf ein Verfahren nach Anspruch 10.

### Kurzbeschreibung der Figuren

Die Ausführungsbeispiele der vorliegenden Erfindung werden besser verstanden von der folgenden detaillierten Beschreibung und den beiliegenden Zeichnungen der unterschiedlichen Ausführungsbeispielen, die jedoch nicht so verstanden werden sollten, dass sie die Offenbarung auf die spezifischen Ausführungsformen einschränkt, sondern lediglich der Erklärung und dem Verständnis dienen.
- Fig. 1: zeigt ein Schaltkonzept zum besseren Verständnis der vorliegenden Erfindung.
- Fig. 2: zeigt ein Schaltkonzept mit zwei Highside-Schaltern.
- Fig. 3: zeigt ein Schaltkonzept mit Halbleiterbauelementen als Schalter.
- Fig. 4: zeigt ein weiteres Schaltkonzept mit Halbleiterbauelementen als Schalter.
- Fig. 5: zeigt ein erfindungsgemäßes Ausführungsbeispiel.
- Fig. 6: zeigt ein Flussdiagram für ein Verfahren zum Schalten gemäß einem Ausführungsbeispiel der vorliegenden Erfindung.
- Fig. 7: zeigt ein konventionelles Schaltkonzept.

### Detaillierte Beschreibung

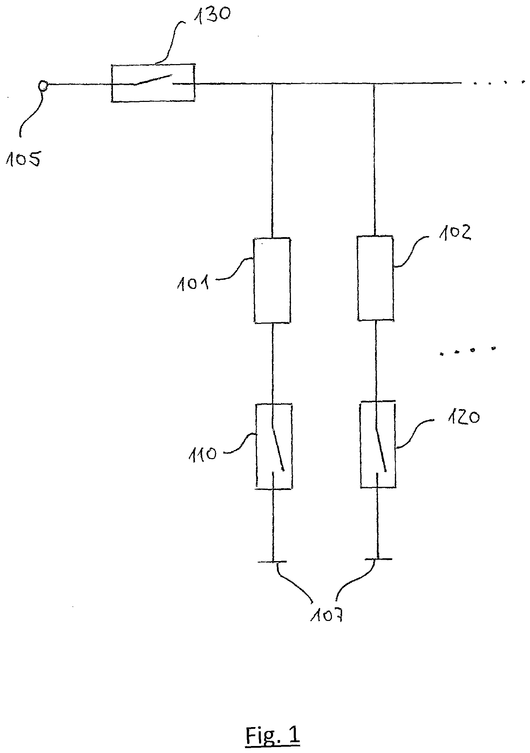

Fig. 1 zeigt eine Schaltvorrichtung gemäß einem Schaltkonzept.

Die Schaltvorrichtung ist geeignet zum Schalten eines ersten Aktuators 101 und eines zweiten Aktuators 102 zwischen einer Stromversorgung 105 und einer Masse 107. Die Schaltvorrichtung umfasst die folgenden Merkmale: einen ersten Schalter 110 zum Schalten eines ersten Strompfades zwischen dem ersten Aktuator 101 und der Masse 107; einen zweiten Schalter 120 zum Schalten eines zweiten Strompfades zwischen dem zweiten Aktuator 102 und der Masse 107; und einen dritten Schalter 130 zum Schalten eines Strompfades zwischen der Stromversorgung 105 und dem ersten Aktuator 101 und eines Strompfades zwischen der Stromversorgung 105 und dem zweiten Aktuator 102, wobei das Schalten des dritten Schalters 130 den Strompfad zum ersten Aktuator 101 und gleichzeitig zum zweiten Aktuator 102 schließt oder öffnet. Wie in der Fig. 1 gezeigt, kann sich dafür der Strompfad stromabwärts vom dritten Schalter (ausgehend von der Stromversorgung 105) verzweigen und zum ersten und zweiten Aktuator 101, 102 führen.

Beispielhaft sind die Aktuatoren beliebige Verbraucher oder Lasten, die nicht zur Schaltvorrichtung zu gehören brauchen, sondern nur durch diese an eine Strom- oder Spannungsversorgung angeschlossen werden.

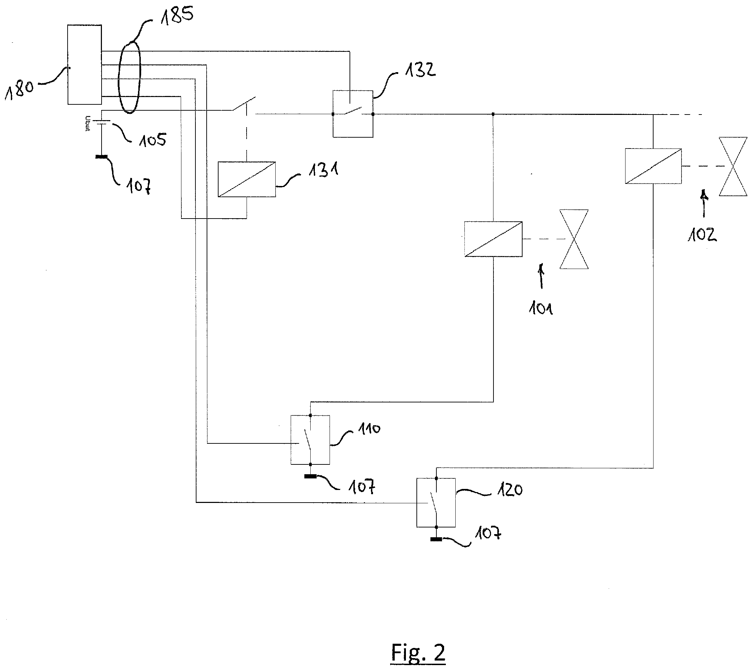

Fig. 2 zeigt ein weiteres Schaltkonzept, wobei der dritte Schalter 130 eine erste Schalteinheit 131 und eine zweite Schalteinheit 132 aufweist. Die erste Schalteinheit 131 ist zwischen der zweiten Schalteinheit 132 und der Stromversorgung 105 (bzw. der Spannungsquelle) geschaltet. Zwischen der zweiten Schalteinheit 132 und der Masse 107 ist der zweite Aktuator 102 seriell mit dem zweiten Schalter 120 geschaltet. Außerdem sind zwischen der zweiten Schalteinheit 132 und der Masse 107 seriell der erste Aktuator 101 und der erste Schalter 110 geschaltet. In diesen seriellen Verschaltungen ist der zweite Schalter 120 zwischen dem zweiten Aktuator 102 und der Masse 107 geschaltet und der erste Schalter 110 ist zwischen dem ersten Aktuator 101 und der Masse 107 geschaltet.

Die Schaltvorrichtung gemäß dem gezeigten Konzept umfasst weiter eine Steuereinheit 180. Außerdem sind die erste Schalteinheit 131, die zweite Schalteinheit 132, der erste Schalter 110 und der zweite Schalter 120 über Steuerleitungen 185 mit der Steuereinheit 180 verbunden. Die Steuereinheit 180 ist ausgebildet, selektiv die einzelnen Schalter 110, 120, 130 bzw. Schaltereinheiten 131, 132 zu öffnen und zu schließen.

Der erste Aktuator 101 und der zweite Aktuator 102 können beispielsweise magnetgesteuerte Ventile oder andere Aktuatoren sein, die über eine Spannungs- oder Stromzuführung betätigt werden können. Beispielhaft sind neben dem ersten Aktuator 101 und dem zweiten Aktuator 102 weitere Aktuatoren vorgesehen, die ebenfalls zwischen der zweiten Schalteinheit 132 und der Masse 107 seriell mit weiteren Schaltern geschaltet sind, und zwar in der gleichen Art und Weise angeordnet, wie der erste Aktuator 101 und der zweite Aktuator 102 in der Fig. 2. Das Vorhandensein dieser weiteren Aktuatoren ist in der Fig. 2 durch die gestrichelte Linie oberhalb des zweiten Aktuators 102 angedeutet.

In dem in der Fig. 2 gezeigten Schaltkonzept verläuft somit der erste Strompfad von der Strom- oder Spannungsquelle 105 über die erste Schalteinheit 131, die zweite Schalteinheit 132, den ersten Aktuator 101 und den ersten Schalter 110 hin zur Masse 107 (oder umgekehrt dazu). Der zweite Strompfad verläuft von der Strom- oder Spannungsquelle 105 über die erste Schalteinheit 131, die zweite Schalteinheit 132, den zweiten Aktuator 102 und den zweiten Schalter 120 hin zur Masse 107 (oder umgekehrt dazu).

Ein Pol der Spannungsversorgung ist auf die Masse 107 gelegt, so dass der andere Pol die Stromversorgung 105 oder die Highside (hohes Potential im Vergleich zur Masse 107) darstellt. Die erste Schalteinheit 131 und die zweite Schalteinheit 132 sind somit Highside-Schalter. Andererseits sind der erste Schalter 110 und der zweite Schalter 120 jeweils ein Lowside-Schalter, da sie direkt an die Masse 107 koppeln.

Die Steuereinheit 180 ist nun ausgebildet, um den dritten Schalter 130 (die erste Schalteinheit 131 und/oder die zweite Schalteinheit 132) zu schalten, wenn einer der Aktuatoren 101, 102 angesteuert werden soll. Zeitgleich schaltet die Steuereinheit 180 zumindest einen der Lowside-Schalter 110, 120, um so zumindest einen Strompfad zu schließen (oder zu öffnen). Um ein häufiges Schalten zu vermeiden, kann die Steuereinheit 180 weiter ausgebildet sein, den Highside-Schalter 130 nur dann zu aktivieren, wenn gerade ein Regeleingriff bevorsteht. Ein solcher Regeleingriff kann beispielsweise ein Ansteuern der Endstufen zur Betätigung der Aktuatoren wie beispielsweise ein Öffnen oder Schließen von druckgesteuerten Ventilen oder ähnliches sein.

Bei weiteren Schaltungen ist es vorteilhaft, wenn der Highside-Schalter 130 zeitlich bereits etwas vor dem gewünschten Einschaltzeitpunkt des entsprechenden Aktuators 101, 102 eingeschaltet wird und/oder etwas nach diesem Zeitpunkt geschaltet wird. Dies kann beispielsweise sinnvoll sein, wenn ein erneuter Regeleingriff bevorsteht.

Somit sind gemäß der vorliegenden Schaltkonzepte die Highside- und Lowside-Schalter entsprechend vertauscht. Da die Lowside-Schalter preisgünstiger und leistungsfähiger sind und außerdem eine größere Vielfalt von Lowside-Schalter vorhanden ist, ist eine solche Anordnung kostengünstig und daher vorteilhaft. Ebenfalls ist es mit diesem Konzept möglich, anwendungsspezifische integrierte Schaltungen zu nutzen, die bereits Lowside-Schalter integriert haben. Da außerdem der Highside-Schalter 130 nur angesteuert wird, wenn zumindest einer der Aktuatoren angesteuert werden soll (oder bei Testimpulsen), hat man den gleichen Schutz vor Korrosion, wie dies bei konventionellen Systemen möglich ist. Ein weiterer Vorteil besteht darin, dass auf einen zusätzlichen vorangestellten Highside-Schalter verzichtet werden kann - insbesondere dann, wenn die Highside-Schalter 130 als Halbleiterbauelemente ausgeführt sind, die schneller schalten als ein Relais und unempfindlicher sind gegenüber mechanischen Belastungen, wie beispielsweise ein Schütteln. Daher ist die erste Schalteinheit 131 oder die zweite Schalteinheit 132 optional. Weitere Schaltkonzepte umfassen somit entweder die erste Schalteinheit 131 oder die zweite Schalteinheit 132, aber nicht beide.

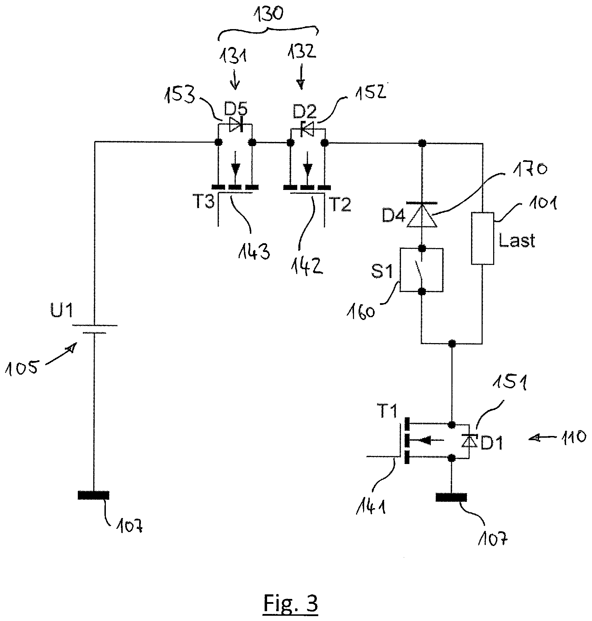

Die Fig. 3 zeigt ein weiteres Schaltkonzept, bei welchem die Schalter als Halbleiterbauelemente ausgebildet sind. Die Fig. 3 zeigt lediglich eine Last 101, die beispielsweise einem der Aktuatoren 101, 102 aus der Fig. 2 entsprechen kann. Diese eine Last 101 ist lediglich der Vereinfachung gezeigt und ist nicht einschränkend auszulegen. Vielmehr können bei weiteren Schaltkonzepten mehrere Lastelemente vorhanden sein, die ähnlich angeordnet sind, wie die Aktuatoren 101, 102 aus der Fig. 2.

In dem gezeigten Schaltkonzept umfasst der erste Schalter 110 einen ersten Transistor 141 (T1) und eine erste Diode 151 (D1). Die zweite Schalteinheit 132 umfasst einen zweiten Transistor 142 (T2) und eine zweite Diode 152 (D2), und die erste Schalteinheit 131 umfasst einen dritten Transistor 143 (T3) und eine dritte Diode 153 (D5). Die Transistoren können Feldeffekttransistoren (FETs) sein und die Dioden können wie folgt angeordnet werden. Parallel zum ersten Transistor 141 ist die erste Diode 151 ausgebildet, parallel zu dem zweiten Transistor 142 ist die zweite Diode 152 ausgebildet und parallel zu dem dritten Transistor 143 ist die dritte Diode 153 ausgebildet. Dioden wie die erste bis dritte Diode 151, 152, 153 sind stets in einem Feldeffekttransistor vorhanden, dienen hier jedoch als Veranschaulichung (als Ersatzschaltbild) um die folgenden Funktionen besser zu verstehen. Diese Dioden kommen durch den Bulkkontakt (oder Substratkontakt) in den Feldeffekttransistoren zustande, wobei die Richtung durch die zwei Möglichkeiten, das FET-Substrat zu kontaktieren, gegeben sind (Verbindung mit Source oder Drain). Sie können wahlweise als Zener-Dioden ausgebildet sein, um einen Überspannungsschutz zu bieten. Die Dioden sind dabei derart geschaltet oder gepolt, dass bei einem deaktivierten Aktuator nur ein geringer Strom durch sie fließt.

Außerdem ist in dem gezeigten nicht zur Erfindung gehörenden Schaltkonzept ein erster Zusatzschalter 160 und eine Zusatzdiode 170 vorhanden, die seriell miteinander verschaltet sind und die Last 101 überbrücken. Die Anordnung der ersten Schalteinheit 131, der zweiten Schalteinheit 132, der Last 101 und des dritten Schalters 130 ist dabei analog zu dem in der Fig. 2 gezeigten Schaltkonzept. Daher ist zwischen der Spannungsquelle 105 und der Last 101 der dritte Schalter 130 angeordnet, und zwar derart, dass die erste Schalteinheit 131 zwischen der zweiten Schalteinheit 132 und der Spannungsquelle 105 geschaltet ist und die zweite Schalteinheit 132 zwischen der ersten Schalteinheit 131 und der Last 101 geschaltet ist. Außerdem ist der erste Schalter 110 zwischen der Masse 107 und er Last 101 geschaltet, so dass ein Strompfad, ausgehend von der Spannungsquelle 105 zunächst die erste Schalteinheit 131 passiert, dann die zweite Schalteinheit 132, dann die Last 101 und schließlich den ersten Schalter 110 passiert, bevor der Strom zur Masse 107 gelangt (oder der Stromfluss erfolgt umgekehrt dazu).

Die erste Schalteinheit 131 und die zweite Schalteinheit 132 sind dabei antiseriell geschaltet, um einen Verpolungsschutz bereitzustellen. Die zweite Diode 152 kann beispielsweise als eine Zenerdiode ausgebildet sein. Ebenso kann die erste Diode 151 als eine Zenerdiode in dem ersten Schalter 110 ausgebildet sein. Diese Zenerdioden dienen dem Schutz. Beispielsweise kann es bei einem plötzlichen Abschalten der Last 101 zu Spannungsspitzen kommen, die nicht an dem zweiten Transistor 142 bzw. den ersten Transistor 141 anliegen sollten. Da die Zener-Dioden Spannungsbegrenzungselemente sind, dienen sie als Schutz für die Transistoren. Die Zenerdioden D1 und D2 dienen aber nicht nur dem Schutz, sondern bedingen durch die beim Abschalten von dem ersten Transistor T1 oder von dem zweiten Transistor T2 darin entstehende hohe Verlustleistung ein schnelles Deaktivieren des Aktuators 101 (die im Aktuator 101 gespeicherte Energie wird dadurch schneller abgebaut). Damit sie diese Funktion erfüllen, werden die Zener-Dioden entsprechend gepolt. Die Polung kann durch eine entsprechende Kontaktierung des Bulkkontaktes des FET erreicht werden.

Der Zusatzschalter 160 und die Zusatzdiode 170, die zwischen einem Eingang und Ausgang der Last 101 seriell geschaltet sind, dienen einem Löschen der Last 101, d.h. dem Abbau der Feldenergie bei einem plötzlichen Abschalten der Last 101 durch ein Öffnen des ersten Schalters 110 und/oder des dritten Schalters 130. So wird durch ein Schließen des Zusatzschalters 160 ein Kreislauf zwischen der Last, dem Zusatzschalter 160 und der Zusatzdiode 170 geschaltet. Die Diode ist so gepolt, dass der Strom-Kreislauf beim Löschen angeregt wird. Da über eine gewisse Zeitperiode ein Kreisstrom über diesen Kreislauf fließt, wird ein Löschen der Last 101 verlangsamt. Der Sinn der langsamen Löschung liegt darin, die im Aktuator 101 gespeicherte Energie bei PWM-Betrieb (über den ersten Transistor T1 oder den zweiten Transistor T2) zu erhalten. Andererseits, wenn der Zusatzschalter 160 geöffnet ist, erfolgt ein Löschen der Last 101 über den ersten Schalter 110 hin zur Masse 107. Dieser Löschvorgang erfolgt schneller, allerdings mit dem Nachteil, dass plötzliche Spannungsspitzen auftreten können (durch die vorhandene Feldenergie). Dieser Lösch-Stromfluss erfolgt über die erste Diode 151 für den gezeigten Aktuator 101 (oder andere einzelne Aktuatoren) oder analog über die zweite und dritte Diode 152, 153 für alle Aktuatoren und er erfolgt schnell, da ein höheres Potential (bei einem geöffneten Zusatzschalter 160) vorhanden ist, welches einen höheren Stromfluss als beim langsamen Löschen bewirkt.

Das Schaltkonzept, wie es in der Fig. 3 gezeigt ist, umfasst somit einen Highside-Schalter 130 aus einem Verpolungs-Feldeffekttransistor T3 (in diesem Beispiel der dritte FET 143) und einem Schalt-Feldeffekttransistor T2 (in diesem Beispiel der zweite FET 142). Um den Lowside-Schalter 110 (d.h. den erste FET 141) bei Abschaltung vor Überspannung durch die gespeicherte magnetische Energie in der Last zu schützen, wird die Schutzdiode D1 (z.B. die Zenerdiode 151) verwendet, die beim Abschaltung und beim Auftreten der Spannungsspitzen leitend wird und diese Energie abbaut. Eine solche Schutzdiode kann auch Bestandteil eines oder mehrerer Highside- und/oder Lowside-Schaltern sein (wie beispielsweise die zweite Diode 152 in der zweiten Schalteinheit 132).

Der zusätzliche Schalter S1 und die Diode D4 (Zusatzdiode 170) können entlang des Strompfades optional vertauscht werden. Somit ist ebenso möglich, durch den zusätzlichen Schalter (in diesem Beispiel der Zusatzschalter 160) vor der Diode D4 zwischen einemschnellen Löschen (Zusatzschalter 160 ist geöffnet) und langsamen Löschen (Zusatzschalter 160 ist geschlossen) zu schalten.

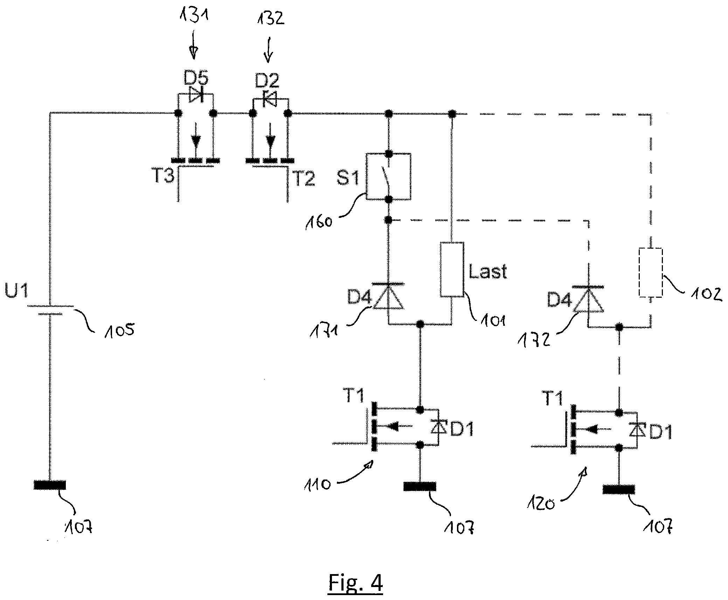

Die Fig. 4 zeigt ein weiteres Schaltkonzept, welches sich von dem Schaltkonzept der Fig. 3 lediglich dadurch unterscheidet, dass ein gemeinsamer Zusatzschalter 160 für mehrere Lastelemente 101, 102, ... vorhanden ist. Die zusätzlichen Lastelemente 102 sind wie in der Fig. 2 angeordnet, wobei parallel zu jedem weiteren Lastelement eine weitere Zusatzdiode D4 und der Zusatzschalter S1 derart seriell geschaltet sind, dass die weitere Zusatzdiode (z.B. die weitere Zusatzdiode 172) zwischen dem Zusatzschalter S1 und der jeweiligen Last 102 geschaltet ist.

Wie zuvor bereits gesagt, können die Schaltkonzepte der Fig. 3 und 4 entsprechend für mehrere Aktuatoren (zusätzlich zu der Last 101) analog umgesetzt werden und für jede zusätzliche Last kann optional ein weiterer Schalter zwischen der zusätzlichen Last und der Masse 107 vorhanden sein. Auch damit wird ein selektives Schalten der weiteren Last-Elemente ermöglicht. Wie in der Fig. 4 gezeigt, kann aber auch ein gemeinsamer Zusatzschalter 160 für alle oder mehrere Aktuatoren vorhanden sein (muss es aber nicht).

Somit dient in dem Schaltkonzept der Fig. 4 der Zusatzschalter S1 als gemeinsamer Schalter zum Umschalten zwischen einem schnellen Löschen und einem langsamen Löschen für alle oder zumindest einem Teil der Aktuatoren (Lastelementen). Die sonstige Funktionsweise ist gleich zu dem Schaltkonzept der Fig. 3, sodass eine wiederholte Beschreibung der Elemente nicht erforderlich ist.

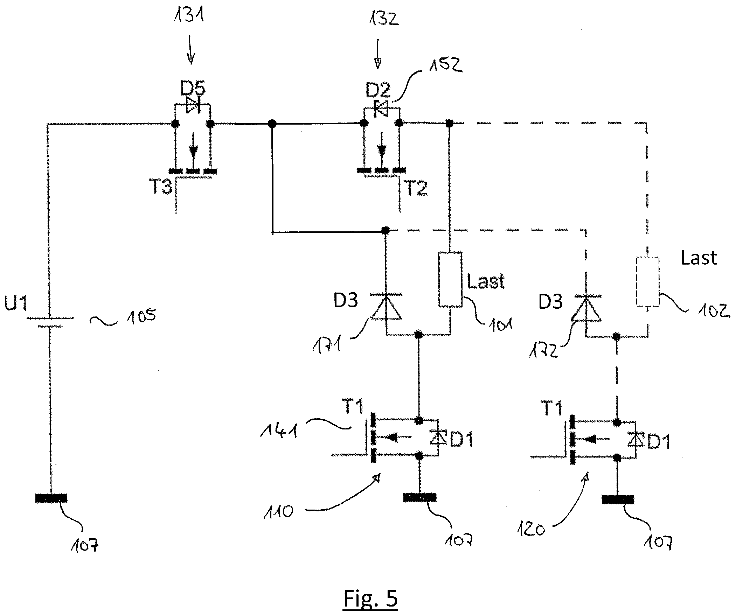

Fig. 5 zeigt ein Ausführungsbeispiel der Erfindung, das als eine Optimierung des Schaltkonzepts aus der Fig.4 betrachtet werden kann. Es unterscheidet sich von der Fig. 4 lediglich dadurch, dass der Zusatzschalter 160 nicht ausgebildet ist. Stattdessen kontaktieren die Zusatzdioden 171, 172 den Strompfad zwischen der ersten Schalteinheit 131 und der zweiten Schalteinheit 132. Somit wird erreicht, dass die schnelle Abschaltung einzelner Aktuatoren über die zweite Schalteinheit 132 (T2/D2) ausgeführt wird. In diesem Fall übernimmt die zweite Diode 152 (D2) die Abschalt-Verlustleistung aller zuvor aktivierten Aktuatoren. Ein langsames Schalten kann in diesem Ausführungsbeispiel (wegen PWM-Betrieb) über den ersten Transistor 141 (T1) und die Zusatzdiode 171 (D3) ausgeführt werden. Eine erneute Beschreibung der zuvor bereits beschriebenen Komponenten ist hier nicht erforderlich.

Bei weiteren Ausführungsbeispielen können die Highside-Schalter (die erste und zweite Schalteinheit 131, 132) als kostengünstige Relais ausgeführt sein. Die ist insbesondere dann sinnvoll, wenn keine zeitkritischen Anwendungen gewünscht sind, da die Relais im Allgemeinen langsamer schalten als Halbleiterschalter. Vorteilhaft ist es ferner, dass die Highside-Schalter 131, 132 als Halbleiterschalter ausgebildet werden, anstatt als mechanischen Relais, da hiermit eine geringere Schaltzeit erreicht werden kann. Dies ist jedoch nicht zwingend und hängt, wie gesagt, von der vorgesehenen Anwendung ab.

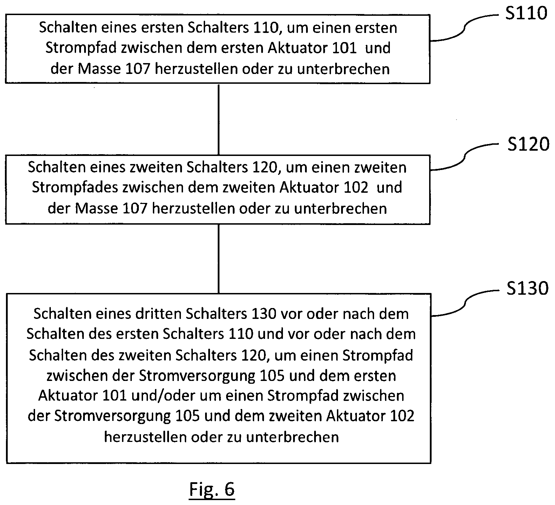

Figur 6 zeigt ein Flussdiagramm eines erfindungsgemäßen Verfahrens, zum Schalten einer erfindungsgemäßen Vorrichtung. Das Verfahren umfasst: ein Schalten S110 eines ersten Schalters 110, um einen ersten Strompfad zwischen dem ersten Aktuator 101 und der Masse 107 herzustellen oder zu unterbrechen und/oder ein Schalten S120 eines zweiten Schalters 120, um einen zweiten Strompfades zwischen dem zweiten Aktuator 102 und der Masse 107 herzustellen oder zu unterbrechen. Das Verfahren umfasst weiter ein Schalten S130 eines dritten Schalters 130, um einen Strompfad zwischen der Stromversorgung 105 und dem ersten Aktuator 101 und/oder um einen Strompfad zwischen der Stromversorgung 105 und dem zweiten Aktuator 102 herzustellen oder zu unterbrechen. Der dritte Schalter 130 schließt oder öffnet durch das Schalten den Strompfad zum ersten Aktuator 101 und/oder gleichzeitig zum zweiten Aktuator 102.

Die genannte Reihenfolge der Schritte impliziert keine zeitliche Abfolge oder nur insoweit, wie es zwingend erforderlich ist.

Eine elektrische Verbindung muss nicht notwendigerweise eine direkte elektrische Verbindung umfassen. Im Rahmen der vorliegenden Erfindung ist unter einer elektrischen Verbindung, das Ausbilden eines Strompfades zu verstehen, der einen Fluss von elektrischen Ladungsträgern zwischen den Komponenten erlaubt. Der Begriff "Koppeln" ist so auszulegen, dass es jegliche Verbindung umfasst, über die eine Energie transportiert werden kann.

### Bezugszeichenliste

- 101: erster Aktuators
- 102: zweiten Aktuator
- 105: Stromversorgung (oder Spannungsquelle)
- 107: Masse
- 110: erster Schalter
- 120: zweiter Schalter
- 130: dritter Schalter
- 131: erste Schalteinheit
- 132: zweite Schalteinheit
- 141, 142, ...: Transistoren
- 151, 152, ...: Dioden
- 160: Zusatzschalter
- 170, 171,...: Zusatzdioden
- 180: Steuereinheit
- 185: Steuerverbindungen

## Patentansprüche

1. Schaltvorrichtung zum Schalten eines ersten Aktuators (101) und eines zweiten Aktuators (102) zwischen einer Stromversorgung (105) und einer Masse (107), mit folgenden Merkmalen:
einen ersten Schalter (110) zum Schalten eines ersten Strompfades zwischen dem ersten Aktuator (101) und der Masse (107);
einen zweiten Schalter (120) zum Schalten eines zweiten Strompfades zwischen dem zweiten Aktuator (102) und der Masse (107);
einen dritten Schalter (130) zum Schalten eines Strompfades zwischen der Stromversorgung (105) und dem ersten Aktuator (101) und eines Strompfades zwischen der Stromversorgung (105) und dem zweiten Aktuator (102), wobei der dritte Schalter (130) durch das Schalten den Strompfad zum ersten Aktuator (101) und zum zweiten Aktuator (102) gleichzeitig schließt oder öffnet; und
eine Steuereinheit (180), wobei die Steuereinheit (180) ausgebildet ist, um den ersten Schalter (110) nach oder vor dem dritten Schalter (130) oder den zweiten Schalter (120) nach oder vor dem dritten Schalter (130) zu schließen oder zu öffnen,
**dadurch gekennzeichnet, dass**
der dritte Schalter (130) eine erste Schalteinheit (131) und eine zweite Schalteinheit (132) aufweist, die seriell geschaltet sind und durch die Steuereinheit unabhängig voneinander schaltbar sind, und **dass**
die Schaltvorrichtung zumindest eine Zusatzdiode (170) umfasst, die einen Strompfad zwischen der ersten Schalteinheit (131) und der zweiten Schalteinheit (132) kontaktiert und den ersten Aktuator (101) und/oder den zweiten Aktuator (102) überbrückt, um ein Löschen des ersten Aktuators (101) und/oder des zweiten Aktuators (102) durch ein Schalten der ersten Schalteinheit (131) oder der zweite Schalteinheit (132) zu beschleunigen oder zu verlangsamen.

2. Schaltvorrichtung nach Anspruch 1, wobei der erste Schalter (110) und der zweite Schalter (120) Lowside-Schalter sind, und der dritte Schalter (130) ein Highside-Schalter ist.

3. Schaltvorrichtung nach Anspruch 1 oder Anspruch 2, wobei der erste Schalter (110) und/oder der zweite Schalter (120) und/oder der dritte Schalter (130) eine Halbleiterschalteinheit oder ein Relais umfassen.

4. Schaltvorrichtung nach Anspruch 3, wobei die Halbleiterschalteinheit einen Feldeffekttransistor (153) umfasst.

5. Schaltvorrichtung nach Anspruch 4, wobei der Feldeffekttransistor des ersten Schalters (110) ein erster Feldeffekttransistor (141) ist und der Feldeffekttransistor des zweiten Schalters (120) ein weiterer Feldeffekttransistor ist und die Schaltvorrichtung weiter ein erstes Spannungsbegrenzungselement (151) und ein weiteres Spannungsbegrenzungselement umfasst,
wobei das erste Spannungsbegrenzungselement (151) parallel zum ersten Feldeffekttransistor (141) und das weitere Spannungsbegrenzungselement parallel zum weiteren Feldeffekttransistor ausgebildet sind.

6. Schaltvorrichtung nach einem der vorhergehenden Ansprüche, wobei die erste Schalteinheit (131) und die zweite Schalteinheit (132) des dritten Schalters (130) jeweils einen Feldeffekttransistor (151, 152) umfassen und antiseriell miteinander verschaltet sind, um einen Verpolungsschutz zu bieten.

7. Schaltvorrichtung nach Anspruch 6, wobei die erste Schalteinheit (131) zwischen der zweiten Schalteinheit (132) und der Stromversorgung (105) geschaltet ist und parallel zum Feldeffekttransistor (152) der zweiten Schalteinheit (132) ein Spannungsbegrenzungselement (152) ausgebildet ist.

8. Schaltvorrichtung nach einem der vorhergehenden Ansprüche, wobei die zumindest eine Zusatzdiode (170) mehrere Zusatzdioden sind, die derart geschaltet sind, dass zu dem ersten und zu dem zweiten Aktuator (101, 102) jeweils eine der mehreren Zusatzdioden (170) parallel sind.

9. Bremssystem eines Fahrzeuges mit einem ersten druckgesteuerten Ventil und einem zweiten druckgesteuerten Ventil und einer Schaltvorrichtung nach einem der Ansprüche 1 bis 8, wobei der erste Aktuator (101) das erste druckgesteuerte Ventil ist und der zweite Aktuator (102) das zweite druckgesteuerte Ventil ist.

10. Verfahren zum Schalten eines ersten Aktuators (101) und eines zweiten Aktuators (102) zwischen einer Stromversorgung (105) und einer Masse (107), mit folgenden Schritten:
Schalten (S110) eines ersten Schalters (110), um einen ersten Strompfad zwischen dem ersten Aktuator (101) und der Masse (107) herzustellen oder zu unterbrechen; und/oder
Schalten (S120) eines zweiten Schalters (120), um einen zweiten Strompfades zwischen dem zweiten Aktuator (102) und der Masse (107) herzustellen oder zu unterbrechen; und
Schalten (S130) eines dritten Schalters (130) vor oder nach dem Schalten (S110) des ersten Schalters (110) und vor oder nach dem Schalten (S120) des zweiten Schalters (120), um einen Strompfad zwischen der Stromversorgung (105) und dem ersten Aktuator (101) und/oder um einen Strompfad zwischen der Stromversorgung (105) und dem zweiten Aktuator (102) herzustellen oder zu unterbrechen, wobei der dritte Schalter (130) durch das Schalten den Strompfad zum ersten Aktuator (101) und zum zweiten Aktuator (102) gleichzeitig schließt oder öffnet,
**gekennzeichnet durch**
ein Schalten einer ersten Schalteinheit (131) oder einer zweiten Schalteinheit (132), um ein Löschen des ersten Aktuators (101) und/oder des zweiten Aktuators (102) zu beschleunigen oder zu verlangsamen,
wobei der dritte Schalter (130) die erste Schalteinheit (131) und die zweite Schalteinheit (132) aufweist, die seriell geschaltet sind und unabhängig voneinander durch eine Steuereinheit schaltbar sind, und über zumindest eine Zusatzdiode (170) ein Strompfad zwischen der ersten Schalteinheit (131) und der zweiten Schalteinheit (132) kontaktiert wird und den ersten Aktuator (101) und/oder den zweiten Aktuator (102) überbrückt wird.

## Claims

1. Switching apparatus for switching a first actuator (101) and a second actuator (102) between a power supply (105) and a ground (107), having the following features:
a first switch (110) for switching a first current path between the first actuator (101) and the ground (107);
a second switch (120) for switching a second current path between the second actuator (102) and the ground (107);
a third switch (130) for switching a current path between the power supply (105) and the first actuator (101) and a current path between the power supply (105) and the second actuator (102), wherein, as a result of the switching, the third switch (130) simultaneously closes or opens the current path to the first actuator (101) and to the second actuator (102); and
a control unit (180), wherein the control unit (180) is designed to close or to open the first switch (110) before or after the third switch (130) or the second switch (120) before or after the third switch (130),
**characterised in that**
the third switch (130) has a first switching unit (131) and a second switching unit (132), which are connected in series and can be switched independently of one another by the control unit, and **in that** the switching apparatus comprises at least one supplementary diode (170), which contacts a current path between the first switching unit (131) and the second switching unit (132) and bridges the first actuator (101) and/or the second actuator (102) in order to accelerate or decelerate a removal of the first actuator (101) and/or the second actuator (102) by a switching of the first switching unit (131) or the second switching unit (132).

2. Switching apparatus according to claim 1, wherein the first switch (110) and the second switch (120) are low-side switches and the third switch (130) is a high-side switch.

3. Switching apparatus according to claim 1 or claim 2, wherein the first switch (110) and/or the second switch (120) and/or the third switch (130) comprise(s) a semiconductor switching unit or a relay.

4. Switching apparatus according to claim 3, wherein the semiconductor switching unit comprises a field-effect transistor (153).

5. Switching apparatus according to claim 4, wherein the field-effect transistor of the first switch (110) is a first field-effect transistor (141) and the field-effect transistor of the second switch (120) is a further field-effect transistor and the switching apparatus further comprises a first voltage-limiting element (151) and a further voltage-limiting element,
wherein the first voltage-limiting element (151) is formed in parallel with the first field-effect transistor (141) and the further voltage-limiting element is formed in parallel with the further field-effect transistor.

6. Switching apparatus according to any of the preceding claims, wherein the first switching unit (131) and the second switching unit (132) of the third switch (130) each comprise a field-effect transistor (151, 152) and are interconnected with one another in anti-series in order to provide polarity-reversal protection.

7. Switching apparatus according to claim 6, wherein the first switching unit (131) is connected between the second switching unit (132) and the power supply (105) and a voltage-limiting element (152) is formed in parallel with the field-effect transistor (152) of the second switching unit (132).

8. Switching apparatus according to any of the preceding claims, wherein the at least one supplementary diode (170) is a plurality of supplementary diodes which are connected in such a way that, in each case, one of the plurality of supplementary diodes (170) is connected in parallel with the first and with the second actuator (101, 102)

9. Brake system of a vehicle having a first pressure-controlled valve and a second pressure-controlled valve and a switching apparatus according to any of claims 1 to 8, wherein the first actuator (101) is the first pressure-controlled valve and the second actuator (102) is the second pressure-controlled valve.

10. Method for switching a first actuator (101) and a second actuator (102) between a power supply (105) and a ground (107), having the following steps:
switching (S110) a first switch (110) in order to establish or to interrupt a first current path between the first actuator (101) and the ground (107); and/or
switching (S120) a second switch (120) in order to establish or to interrupt a second current path between the second actuator (102) and the ground (107); and
switching (S130) a third switch (130) before or after switching (S110) the first switch (110) and before or after switching (S120) the second switch (12) in order to establish or to interrupt a current path between the power supply (105) and the first actuator (101) and/or a current path between the power supply (105) and the second actuator (102), wherein, as a result of the switching, the third switch (130) simultaneously closes or opens the current path to the first actuator (101) and to the second actuator (102),
**characterised by**
a switching of a first switching unit (131) or a second switching unit (132) in order to accelerate or decelerate a removal of the first actuator (101) and/or the second actuator (102),
wherein the third switch (130) has the first switching unit (131) and the second switching unit (132), which are connected in series and can be switched independently of one another by the control unit, and wherein, by way of at least one supplementary diode (170), a current path is contacted between the first switching unit (131) and the second switching unit (132) and bridges the first actuator (101) and/or the second actuator (102).

## Revendications

1. Dispositif de commutation pour la commutation d'un premier actionneur (101) et d'un deuxième actionneur (102) entre une alimentation (105) en courant et une masse (107), ayant les caractéristiques suivantes :
un premier interrupteur (110) pour la commutation d'un premier trajet de courant entre le premier actionneur (101) et la masse (107) ;
un deuxième interrupteur (120) pour la commutation d'un deuxième trajet de courant entre le deuxième actionneur (102) et la masse (107) ;
un troisième interrupteur (130) pour la commutation d'un trajet de courant entre l'alimentation (105) en courant et le premier actionneur (101) et d'un trajet de courant entre l'alimentation (105) en courant et le deuxième actionneur (102), le troisième interrupteur (130) fermant ou ouvrant en même temps, par la commutation, le trajet de courant allant au premier actionneur (101) et au deuxième actionneur (102) ; et
une unité (180) de commande, l'unité (180) de commande étant constituée pour fermer ou ouvrir le premier interrupteur (110) après ou avant le troisième interrupteur (130) ou le deuxième interrupteur (120) après ou avant le troisième interrupteur (130),
**caractérisé en ce que**
le troisième interrupteur (130) a une première unité (131) de commutation et une deuxième unité (132) de commutation, qui sont montées en série et qui peuvent être commutées indépendamment l'une de l'autre par l'unité de commande, et **en ce que**
le dispositif de commutation comprend au moins une diode (170) supplémentaire, qui contacte un trajet de courant entre la première unité (131) de commutation et la deuxième unité (132) de commutation et shunte le premier actionneur (101) et/ou le deuxième actionneur (102), afin d'accélérer ou de ralentir un effacement du premier actionneur (101) et/ou du deuxième actionneur (102) par une commutation de la première unité (131) de commutation ou de la deuxième unité (132) de commutation.

2. Dispositif de commutation suivant la revendication 1, dans lequel le premier interrupteur (110) et le deuxième interrupteur (120) sont des interrupteurs lowside et le troisième interrupteur (130) est un interrupteur highside.

3. Dispositif de commutation suivant la revendication 1 ou revendication 2, dans lequel le premier interrupteur (110) et/ou le deuxième interrupteur (120) et/ou le troisième interrupteur (130) comprennent une unité de commutation à semiconducteur ou un relais.

4. Dispositif de commutation suivant la revendication 3, dans lequel l'unité de commutation à semiconducteur comprend un transistor (153) à effet de champ.

5. Dispositif de commutation suivant la revendication 4, dans lequel le transistor à effet de champ du premier interrupteur (110) est un premier transistor (141) à effet de champ et le transistor à effet de champ du deuxième interrupteur (120) est un autre transistor à effet de champ, et le dispositif de commutation comprend en outre un premier élément (151) de limitation de la tension et un autre élément de limitation de la tension,
dans lequel le premier élément (151) de limitation de la tension est constitué en parallèle avec le premier transistor (141) à effet de champ et l'autre élément de limitation de la tension est constitué en parallèle avec l'autre transistor à effet de champ.

6. Dispositif de commutation suivant l'une des revendications précédentes, dans lequel la première unité (131) de commutation et la deuxième unité (132) de commutation du troisième interrupteur (130) comprennent un transistor (151, 152) à effet de champ et sont montées entre elles tête bêche pour donner une polarisation.

7. Dispositif de commutation suivant la revendication 6, dans lequel la première unité (131) de commutation est montée entre la deuxième unité (132) de commutation et l'alimentation (105) en courant, et un élément (152) de limitation de la tension est constitué en parallèle avec le transistor (152) à effet de champ de la deuxième unité (132) de commutation.

8. Dispositif de commutation suivant l'une des revendications précédentes, dans lequel la au moins une diode (170) supplémentaire sont plusieurs diodes supplémentaires, qui sont montées de manière à ce que respectivement l'une des plusieurs diodes (170) supplémentaire soit en parallèle avec le premier et avec le deuxième actionneur (101, 102).

9. Système de freinage d'un véhicule comprenant une première soupape commandée en pression et une deuxième soupape commandée en pression et un dispositif de commutation suivant l'une des revendications 1 à 8, le premier actionneur (101) étant la première soupape commandée en pression et le deuxième actionneur (102) étant la deuxième soupape commandée en pression.

10. Procédé de commutation d'un premier actionneur (101) et d'un deuxième actionneur (102) entre une alimentation (105) en courant et une masse (107) comprenant les stades suivants :
commutation (S110) d'un premier interrupteur (110) pour ménager ou interrompre un trajet de courant entre le premier actionneur (101) et la masse (107) ; et/ou
commutation (S120) d'un deuxième interrupteur (120) pour ménager ou pour interrompre un deuxième trajet de courant entre le deuxième actionneur (102) et la masse (107) ; et
commutation (S130) d'un troisième interrupteur (130) avant ou après la commutation (S110) du premier interrupteur (110) et avant ou après la commutation (S120) du deuxième interrupteur (120) pour ménager ou interrompre un trajet de courant entre l'alimentation (105) en courant et le premier actionneur (101), et/ou un trajet de courant entre l'alimentation (105) en courant et le deuxième actionneur (102), dans lequel le troisième interrupteur (130) ferme ou ouvre en même temps par la commutation le trajet de courant allant au premier actionneur (101) et au deuxième actionneur (102) ,
**caractérisé**
**par** une commutation d'une première unité (131) de commutation ou d'une deuxième unité (132) de commutation pour accélérer ou ralentir un effacement du premier actionneur (101) et/ou du deuxième actionneur (102),
dans lequel le troisième interrupteur (130) a la première unité (131) de commutation et la deuxième unité (132) de commutation, qui sont montées en série et qui peuvent être commutées indépendamment l'une de l'autre par une unité de commande et, par au moins une diode (170) supplémentaire, on contacte un trajet de courant entre la première unité (131) de commutation et la deuxième unité (132) de commutation et on shunte le premier actionneur (101) et/ou le deuxième actionneur (102).
